# EUROPÄISCHE PATENTSCHRIFT

(11) **EP 2 747 531 B1**
(45) Veröffentlichungstag und Bekanntmachung des Hinweises auf die Patenterteilung: **03.06.2020**
(21) Anmeldenummer: 13195965.2
(22) Anmeldetag: 06.12.2013
(51) Int. Cl.: H05K 3/34, H05K 3/30

(54) **Verfahren zur Herstellung von mischbestückten Leiterplatten**
Method for the manufacture of circuit boards with mixed components
Procédé de fabrication de cartes de circuit imprimé à composants mixtes

(30) Priorität: 18.12.2012 DE 102012112503
(43) Veröffentlichungstag der Anmeldung: 25.06.2014
(73) Patentinhaber: Endress+Hauser SE+Co. KG, 79689 Maulburg (DE)
(72) Erfinder: Birgel, Dietmar, 79650 Schopfheim (DE); Hippin, Christoph, 79639 Grenzach (DE); Glatz, Franz, 79106 Freiburg (DE)
(74) Vertreter: Andres, Angelika Maria

(56) Entgegenhaltungen:
- DE-A1-102005 032 135
- DE-A1-102006 035 528
- US-A1- 2002 130 163
- Koki: "Medium melting point solder paste", , 23. September 2009 (2009-09-23), XP055107685, Gefunden im Internet: URL:http://www.adtool.ca/Library/Koki solder paste/Koki SB6N58-A730-3.pdf [gefunden am 2014-03-13]
- Koki: "Koki low melting point lead free solder paste", , 23. April 2009 (2009-04-23), XP055107693, Gefunden im Internet: URL:http://www.adtool.ca/Library/Koki solder paste/TB48-M741.pdf [gefunden am 2014-03-13]

## Beschreibung

Die Erfindung betrifft ein Verfahren zur Herstellung von mischbestückten Leiterplatten, auf denen auf einer ersten Seite mindestens ein THT-Bauteil und mindestens ein SMD-Bauteil und auf einer zweiten Seite mindestens ein SMD-Bauteil vorgesehen ist, sowie eine Fertigungseinrichtung zur Ausführung dieses Verfahrens.

Derartige mischbestückte Leiterplatten werden heutzutage in einer Vielzahl moderner elektrischer Geräte, insb. in Messgeräten, eingesetzt.

Zur Reduktion von Herstellungskosten werden vorzugsweise oberflächenmontierbare Bauteile, so genannte 'Surface Mounted Devices' - kurz SMD-Bauteile eingesetzt. SMD-Bauteile benötigen für deren Montage keine Leiterplattenlöcher, sondern werden mit ihren Anschlüssen direkt auf hierfür auf der Leiterplatte vorgesehene Kontakte gelötet. SMD-Bauteile werden mit Bestückungsautomaten maschinell auf mit Lotpaste versehenen Kontakte auf der Leiterplatte platziert und gemeinsam in einem einzigen Reflowlötprozess aufgelötet. SMD-Bauteile können auf beiden Seiten der Leiterplatte angebracht werden, indem zunächst die erste Seite mit den entsprechenden Bauteilen bestückt wird, diese dort verlötet werden, die Leiterplatte anschließend gewendet wird, und dann die zweite Seite auf die gleiche Weise mit den entsprechenden SMD Bauteilen versehen wird.

Heute sind die meisten elektronischen Bauteile als SMD-Bauteile erhältlich, was zu einer erheblichen Reduktion der Herstellungskosten geführt hat.

Eine weitere große Bauteilgruppe stellen die SMD-lötfähigen Bauteile dar, die auf die gleiche Weise zusammen mit SMD-Bauteilen in einem einzigen Fertigungsprozess auf der Leiterplatte aufgelötet werden können. Hierzu gehören im weitesten Sinn auch die sogenannten PIH Bauteile (Pin In Hole -Bauteile). Dabei handelt es sich um bedrahtete Bauteile, deren Anschlussdrähte auf der Leiterplatte in metallisierte mit Lotpaste bedruckte Sacklochbohrungen hineingesteckt und dort verlötet werden. Nachfolgend wird nicht mehr explizit zwischen SMD-Bauteilen und SMD-lötfähigen Bauteilen unterschieden. Der Begriff SMD-Bauteile wird nachfolgend derart verwendet, dass er auch die SMD-lötfähigen Bauteile umfasst.

Allerdings gibt es auch heute noch eine Vielzahl von Bauteilen, insb. Bauteile die bedingt durch deren Funktion größere Abmessungen aufweisen, wie z.B. Stecker und Übertrager, die nach wie vor bevorzugt als bedrahtete sogenannten THT-Bauteile ausgebildet sind. THT ist die Abkürzung für Through Hole Technique. Diese Bauteile weisen stiftförmige oder drahtförmige Anschlüsse auf, die durch - regelmäßig metallisierte - Anschlussbohrungen in der Leiterplatte hindurch gesteckt und auf der dem Bauteil gegenüberliegenden Seite der Leiterplatte verlötet werden.

Für die Verlötung der auf der auf den dem jeweiligen THT-Bauteil gegenüberliegenden Seite der Leiterplatte befindlichen Lötstellen dieser THT-Bauteile sind Wellenlötverfahren regelmäßig besser geeignet als Reflowlötverfahren, da den Lötstellen beim Wellenlöten eine größere Lotmenge und lokal innerhalb kürzerer Zeit eine größere Wärmemenge zugeführt werden kann.

Zur Reduktion von Fertigungskosten und zur Beschleunigung des Herstellungsprozesses ist man bei der Herstellung von Leiterplatten bemüht, möglichst wenig verschiedene vorzugsweise automatisiert ausführbare Verfahrensschritte einzusetzen, und nach Möglichkeit nur sogenannte Massenlötverfahren einzusetzen, bei denen eine große Anzahl von Bauteilen in einem gemeinsamen Lötvorgang verlötet werden kann.

Ein solches Verfahren zur Herstellung von mischbestückter Leiterplatten, auf deren ersten Seiten THT- und SMD-Bauteile und auf deren zweiten Seiten SMD-Bauteile vorgesehen sind, ist in der DE 10 2006 035 528 beschrieben.
Dort werden in einem ersten Arbeitsgang die auf der zweiten Seite der Leiterplatte vorzusehenden SMD-Bauteile auf der zweiten Seite mit einem Kleber fixiert. Anschließend wird die Leiterplatte gewendet, und deren erste Seite an den für SMD-Bauteile vorgesehenen Lötstellen mit Lotpaste bedruckt. Danach wird die erste Seite mit THT-Bauteilen und SMD-Bauteilen bestückt. Abschließend wird ein Wellenlötverfahren durchgeführt, bei dem die auf der zweiten Seite der Leiterplatte aufgeklebten SMD-Bauteile und die auf der zweiten Seite befindlichen Lötstellen der auf der ersten Seite befindlichen THT-Bauteile verlötet werden. Bei diesem Wellenlötvorgang wird die Leiterplatte derart über die Lotwelle geführt, dass durch eine Wärmeübertragung durch die Leiterplatte hindurch zugleich auch die auf der ersten Seite der Leiterplatte befindlichen SMD-Bauteile verlötet werden. Damit die für die Verlötung der auf der ersten Seite befindlichen SMD-Bauteile erforderliche Wärmeübertragung in ausreichendem Maße stattfindet, wird die Leiterplatte horizontal mit einer gegenüber klassischen Wellenlötverfahren reduzierten Geschwindigkeit über die Lotwelle gefahren.

Das Verfahren weist den Vorteil auf, dass in einem einzigen Wellenlötverfahren Lötstellen auf beiden Seiten der Leiterplatte verlötet werden.
Nachteilig ist jedoch, dass die Transportgeschwindigkeit aufgrund der erforderlichen Wärmeübertragung auf die erste Seite der Leiterplatte nicht an die Bedürfnisse der auf der zweiten Seite durch den unmittelbaren Kontakt mit der Lotwelle zu verlötenden Bauteile angepasst werden kann.

Darüber hinaus besteht beim horizontalen Transport der Leiterplatte eine größere Gefahr dafür, dass sich im Bereich der auf der zweiten Seite befindlichen Lotstellen beim Wellenlöten Lotbrücken oder Lotzapfen ausbilden, als dies bei einem gegenüber der Horizontalen um einen Anstellwinkel geneigten Transport der Leiterplatte über die Lotwelle der Fall wäre.

US 2002/0130163A1 offenbart ein Verfahren zur Herstellung von mischbestückten Leiterplatten, das die Nachteile der DE 10 2006 035 528 vermeidet. Die Leiterplatte wird einer Vorwärmeinreichtung zugeführt, so dass im nachfolgenden kombinierten Reflowofen mit Schwalllötanlage eine zuverlässige Verlötung stattfindet.

Es ist eine Aufgabe der Erfindung ein effizientes Verfahren zur Herstellung von mischbestückten Leiterplatten, auf denen auf einer ersten Seite mindestens ein THT-Bauteil und mindestens ein SMD-Bauteil und auf einer zweiten Seite mindestens ein SMD-Bauteil vorgesehen ist, anzugeben, bei dem auf der zweiten Seite der Leiterplatte befindliche Lötstellen nach Möglichkeit in einem auf deren Bedürfnisse zugeschnittenen Wellenlötverfahren verlötet werden können.

Zur Lösung dieser Aufgabe umfasst die Erfindung ein Verfahren zur Herstellung von mischbestückten Leiterplatten gemäß Anspruch 1, auf deren erster Seite mindestens ein THT-Bauteil und mindestens ein SMD-Bauteil und auf deren zweiter Seite mindestens ein SMD-Bauteil angeordnet ist.

Gemäß einer ersten bevorzugten Ausführungsvariante ist das die niedrige Schmelztemperatur aufweisende Lot ein Zinn-Wismut-Lot, insb. ein Zinn-Wismut-Lot mit eine Schmelztemperatur in der Größenordnung von 140°C.

Gemäß einer zweiten bevorzugten Ausführungsvariante ist das die niedrige Schmelztemperatur aufweisende Lot ein Indium- und/oder Wismut-haltiges Lot, insb. ein

Indium- und/oder Wismut-haltiges Lot mit einer Schmelztemperatur in der Größenordnung von 160°C bis 210°C ist.

Vorzugsweise ist das Indium- und/oder Wismut-haltiges Lot aufweisende Lot ein Indium- und/oder Wismut-haltiges Zinn-Silber Lot, insb. ein Sn3.5Ag0.5Bi6In Lot.

Gemäß einer Weiterbildung wird für das Wellenlötverfahren ein Lot eingesetzt,
- dessen Schmelztemperatur höher ist, als die des auf der ersten Seite der Leiterplatte verwendeten, die niedrige Schmelztemperatur aufweisenden Lots, und
- dessen Schmelztemperatur niedriger als eine Schmelztemperatur desjenigen Lotwellenlots ist, bei dessen Verwendung ein Maximalwert einer beim Wellenlöten auf der ersten Seite der Leiterplatte auftretenden Temperatur die Schmelztemperatur des auf der ersten Seite der Leiterplatte verwendeten Lots erreicht.

Gemäß einer weiteren Ausgestaltung werden die auf der zweiten Seite anzuordnenden SMD-Bauteile an dafür vorgesehenen Positionen auf der zweiten Seite der Leiterplatte mittels eines Klebers aufgeklebt.

Gemäß einer Ausgestaltung wird das die niedrige Schmelztemperatur aufweisende Lot auf der ersten Seite der Leiterplatte als Lotpaste auf darauf befindliche Kontakte für auf der ersten Seite anzuordnende SMD-Bauteile aufgebracht.

Gemäß einer weiteren Ausgestaltung
- weist mindestens eines der auf der ersten Seite anzuordnenden SMD-Bauteile auf dessen der Leiterplatte zuzuwendenden Unterseite angeordnete Lotkugeln auf, die aus dem die niedrige Schmelztemperatur aufweisenden Lot bestehen, und
- werden diese SMD-Bauteile derart auf die erste Seite der Leiterplatte aufgebracht, dass deren Lotkugeln auf zugehörigen Kontakten auf der ersten Seite der Leiterplatte aufliegen.

Weiter umfasst die Erfindung eine Fertigungseinrichtung zur Ausführung des erfindungsgemäßen Verfahrens zur Herstellung von mischbestückten Leiterplatten gemäß Anspruch.

Die Erfindung und weitere Vorteile werden nun anhand der Figuren der Zeichnung, in denen ein Ausführungsbeispiel dargestellt ist, näher erläutert.
- Fig. 1 zeigt:: eine mischbestückte Leiterplatte beim Durchfahren einer einer Wellenlöteinrichtung vorgeschalteten Vorwärmeinrichtung; und
- Fig. 2 zeigt:: Temperaturverläufe der sich auf der ersten und der zweiten Seite der Leiterplatte beim Überfahren der Vorwärmeinrichtung und der Lotwelle einstellenden Temperaturen.

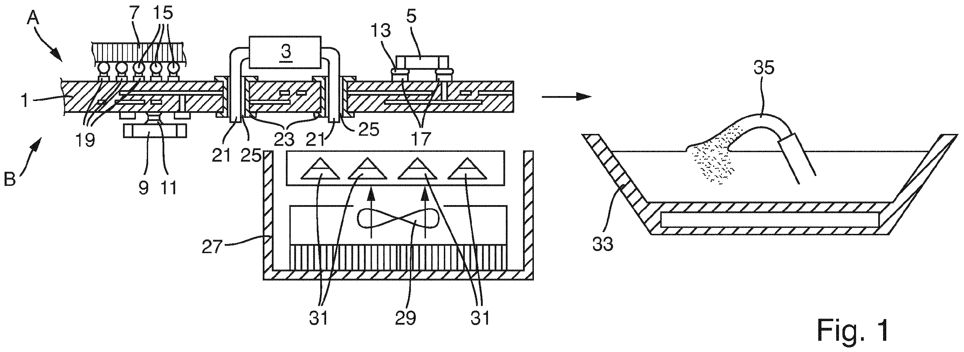

Das erfindungsgemäße Verfahren zur Herstellung einer mischbestückten Leiterplatte 1, auf deren erster Seite A mindestens ein THT-Bauteil 3 und mindestens ein SMD-Bauteil 5, 7 und auf deren zweiten Seite B mindestens ein SMD-Bauteil 9 angeordnet ist, ist nachfolgend anhand des in Fig. 1 dargestellten Ausführungsbeispiels beschrieben. Parallel dazu sind die einzelnen zum Teil in Fig. 1 schematisch dargestellten Bestandteile einer Fertigungseinrichtung zur Ausführung des erfindungsgemäßen Verfahrens beschrieben.

In einem ersten Verfahrensschritt werden die auf der zweiten Seite B der Leiterplatte 1 anzuordnenden SMD-Bauteile 9 an dafür vorgesehenen Positionen auf der zweiten Seite B der Leiterplatte 1 befestigt.

Dies geschieht beispielsweise, indem an den entsprechenden Orten auf der zweiten Seite der Leiterplatte 1 punktuell Kleber 11 aufgetragen wird, und die SMD-Bauteile 9 in den Kleber 11 eingesetzt werden.

Hierzu umfasst die Fertigungseinrichtung beispielsweise einen hier nicht dargestellten Dispenser zum Aufbringen des Klebers 11 und einen - hier ebenfalls nicht dargestellten Bestückungsautomaten zur Bestückung der zweiten Seite mit den SMD-Bauteilen 9.

Nach der Befestigung der SMD-Bauteile 9 wird die Leiterplatte 1 gewendet. Das geschieht vorzugsweise automatisiert mittels einer hier nicht dargestellten WendeVorrichtung.

In einem nächsten Arbeitsgang werden die auf der ersten Seite A anzuordnenden SMD-Bauteile 5, 7 unter Zwischenfügung eines eine niedrige Schmelztemperatur T_{S} aufweisenden Lots 13, 15 auf für deren Anschluss auf der ersten Seite A vorgesehene Kontakte 17, 19 aufgesetzt.

Bei klassischen SMD-Bauteilen, wie dem in Fig. 1 exemplarisch dargestellten SMD-Bauteil 5 geschieht dies vorzugsweise, indem die zugehörigen Kontakte 17 in der Fertigungseinrichtung maschinell mittels einer hier nicht dargestellten Druckvorrichtung mit einer Lotpaste aus dem die niedrige Schmelztemperatur T_{S} aufweisenden Lot 13 bedruckt, und die erste Seite anschließend, vorzugsweise maschinell, mittels eines hier ebenfalls nicht dargestellten Bestückungsautomaten der Fertigungseinrichtung, mit diesen klassischen SMD-Bauteilen 5 bestückt wird.

Daneben können auf der ersten Seite A der Leiterplatte 1 aber auch in Fig. 1 exemplarisch durch das SMD-Bauteil 7 dargestellte Bauteile eingesetzt werden, die auf deren der Leiterplatte 1 zuzuwendenden Unterseite Lotkugeln aus einem die niedrige Schmelztemperatur T_{S} aufweisenden Lot 15 aufweisen. Diese SMD-Bauteile 7 können zusammen mit den klassischen SMD-Bauteilen 5 mit dem Bestückungsautomaten unmittelbar auf die zugehörigen Kontakte 19 aufgesetzt werden, ohne dass diese Kontakte 19 zuvor mit Lotpaste bedruckt werden. Hiernach liegen die Lotkugeln unmittelbar auf den zugehörigen Kontakten 19 auf.

Dabei wird vorzugsweise Lot 13, 15 eingesetzt, das eine Schmelztemperatur kleiner gleich 210°C aufweist. Sofern die nachfolgend noch näher erläuterten Verfahrensparameter dies erlauben, kann hierzu Lot mit einer extrem niedrigen Schmelztemperatur T_{S} eingesetzt werden. Hierzu eignen sich zum Beispiel Zinn-Wismut Lote, die regelmäßig eine Schmelztemperatur T_{S} in der Größenordnung von 140°C aufweisen. Auf diese Weise wird die erste Seite A der Leiterplatte 1 während des gesamten Verfahrens extrem schonend behandelt, so dass hier auch Bauteile mit vergleichsweise geringer thermischer Beständigkeit vorgesehen werden können.

Im Bereich höherer aber immer noch niedriger Schmelztemperaturen T_{S} in der Größenordnung von 160°C bis 210°C, werden bevorzugt Indium- und/oder Wismut-haltige Lote eingesetzt. Dabei bewirkt Indium genau wie Wismut die niedrige Schmelztemperatur T_{S} kleiner gleich 210°C. Indium bewirkt zusätzlich eine größere Duktilität, Wismut eine größere Härte. Als besonders geeignet haben sich insoweit Indium- und/oder Wismut-haltige Zinn-Silber Lote, wie z.B. das Sn3.5Ag0.5Bi6In Lot, erwiesen.

Darüber hinaus wird die erste Seite A mit den darauf anzuordnenden THT-Bauteilen 3 bestückt. Dabei werden deren Anschlüsse 21 durch mit einer Metallisierung 23 ausgestattete Bohrungen 25 auf die zweite Seite B der Leiterplatte 1 geführt. Sofern die Art der einzusetzenden THT-Bauteile 3 dies zulässt, kann deren Bestückung zusammen mit der Bestückung der Leiterplatte 1 mit den SMD-Bauteilen 5, 7 in einem Arbeitsgang durch den Bestückungsautomaten ausgeführt werden.

Erfindungsgemäß durchläuft die nun vollständig bestückte Leiterplatte 1 eine Vorwärmeinrichtung 27, in der das niedrig schmelzende Lot 13, 15 aufgeschmolzen und die auf der ersten Seite angeordneten SMD-Bauteile 5, 7 verlötet werden.

Die Vorwärmeinrichtung 27 ist Bestandteil der Fertigungseinrichtung und umfasst beispielsweise ein Heißluftgebläse 29 und einen oder mehrere diesem vorgelagerten Infrarot-Strahler 31.

Derartige Vorwärmeinrichtungen 27 sind aus dem Stand der Technik bekannt, und werden zum Beispiel zum Vorwärmen von Leiterplatten vor der Durchführung von Wellenlötverfahren eingesetzt. Sie bieten dort, sowie auch hier in dem erfindungsgemäßen Verfahren, den Vorteil, dass vorgewärmte Leiterplatten 1 der Lotwelle 35 beim Wellenlöten weniger thermische Energie entziehen, so dass insgesamt weniger Energie zur Bereitstellung der Lotwelle 35 benötigt wird.

Diese Vorwärmeinrichtungen 27 sind ohne weiteres in der Lage, die auf der ersten Seite A der Leiterplatte 1 befindlichen Lötstellen auf Temperaturen aufzuheizen, bei denen niedrigschmelzende Lote mit Schmelztemperaturen T_{S} kleiner gleich 210°C aufschmelzen. Dabei genügen in der Regel Durchlaufzeiten in der Größenordnung von höchstens wenigen Minuten, z.B. in der Größenordnung von 0, 5 Minuten bis 3 Minuten, um das Lot 13, 15 auf Temperaturen größer gleich dessen niedriger Schmelztemperatur T_{S} aufzuheizen und aufzuschmelzen.

Während dieser Durchlaufzeit überfährt die Leiterplatte 1 die Vorwärmeinrichtung 27 - wie hier dargestellt- horizontal, wobei die zweite Seite B der Leiterplatte 1 der Vorwärmeinrichtung 27 zugewandt ist. Sofern die Temperaturbeständigkeit der auf der ersten Seite A angeordneten Bauteile, insb. die Temperaturbeständigkeit der regelmäßig gegenüber thermischen Belastungen empfindlicheren THT-Bauteile 3, dies zulässt, kann alternativ auch die erste Seite A der Vorwärmeinrichtung 27 zugewandt sein, oder die Vorwärmung zeitgleich von beiden Seiten A und B der Leiterplatte 1 her vorgenommen werden.

Nach dem Durchlaufen der Vorwärmeinrichtung 27 wird die Leiterplatte 1 einer Wellenlöteinrichtung 33 zugeführt, in der sie über eine Lotwelle 35 gefahren wird. Dabei ist die zweite Seite B der Leiterplatte 1 der Lotwelle 35 zugewandt, so dass in diesem Wellenlötverfahren die auf der zweiten Seite B befindlichen SMD-Bauteile 9 und die auf der zweiten Seite B befindlichen Lötstellen der auf der ersten Seite A angeordneten THT-Bauteile 3 verlötet werden. Dabei kann die Transportgeschwindigkeit und der Anstellwinkel um den die Leiterplatte 1 beim Transport über die Lotwelle 35 gegenüber der Horizontalen geneigt ist, weitgehend frei gewählt werden.

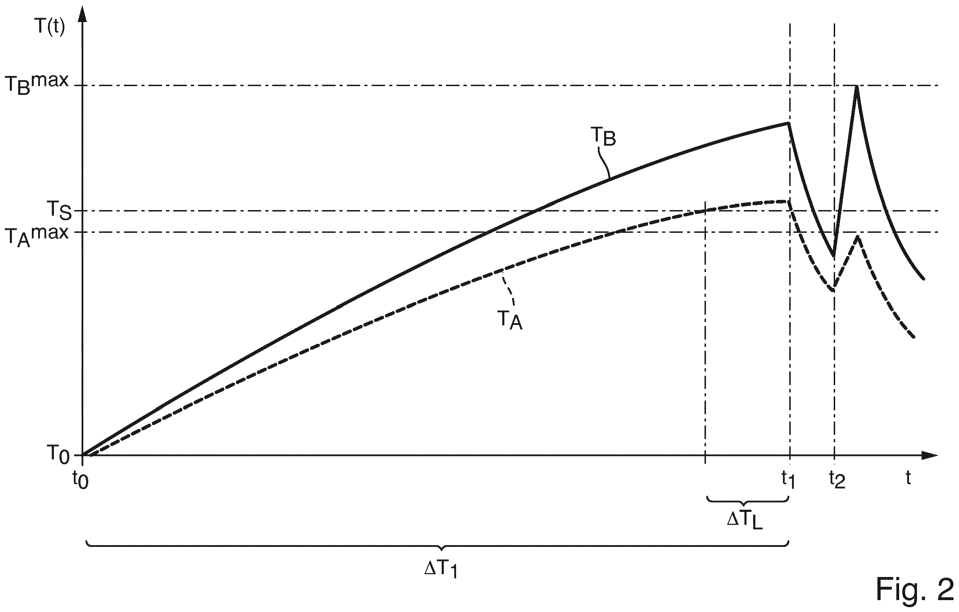

Zur Veranschaulichung sind in Fig. 2 zwei Temperaturverläufe T_{A}(t), T_{B} (t) dargestellt. Der durchweg niedrigere Temperaturen T_{A} aufweisende untere Temperaturverlauf T_{A}(t) gibt die sich auf der ersten Seite A der Leiterplatte 1 beim Überfahren der Vorwärmeinrichtung 27 und der Lotwelle 35 einstellenden Temperaturen T_{A} als Funktion der Zeit t wieder. Der durchweg höhere Temperaturen T_{B} aufweisende obere Temperaturverlauf T_{B}(t) gibt die sich auf der zweiten Seite B der Leiterplatte 1 beim Überfahren der Vorwärmeinrichtung 27 und der Lotwelle 35 einstellenden Temperaturen T_{B} als Funktion der Zeit t wieder.

Anfänglich weist die Leiterplatte 1 insgesamt die Umgebungstemperatur T₀ auf. Sie tritt zum Zeitpunkt t₀ in die Vorwärmeinrichtung 27 und durchläuft diese während eines vorgegebenen Vorwärmintervalls ΔT1. Während dessen steigen die Temperaturen T_{A} auf der ersten Seite A und T_{B} auf der zweiten Seite B der Leiterplatte 1 kontinuierlich an. Da die Vorwärmeinrichtung 27 die Leiterplatte 1 in dem in Fig. 1 dargestellten Ausführungsbeispiel von der zweiten Seite B der Leiterplatte 1 her beheizt, steigt die Temperatur T_{B} auf der zweiten Seite B dabei schneller als die Temperatur T_{A} auf der ersten Seite A. Dabei sind die Heizleistung und die Dauer des Vorwärmintervalls ΔT1 derart zu bemessen, dass die Temperatur T_{A} auf der ersten Seite A am Ende des Vorwärmintervalls ΔT1 für einen zum Aufschmelzen des auf der ersten Seite A befindlichen Lots 13, 15 ausreichend langen Löt-Zeitraum ΔT_{L} geringfügig größer oder gleich der Schmelztemperatur T_{S} dieses Lots 13,15 ist. Hierzu genügt in der Regel eine Vorwärmintervall- Dauer in der Größenordnung von 0, 5 Minuten bis 3 Minuten.

Nach dem Verlassen der Vorwärmeinrichtung 27 zum Zeitpunkt t₁ kühlen beide Seiten A, B der Leiterplatte 1 sehr schnell auf deutlich unterhalb der Schmelztemperatur T_{S} liegende Temperaturwerte ab, bis sie beginnend mit dem Zeitpunkt t₂ beim Überfahren der Lotwelle 35 kurzzeitig aufgeheizt werden.
Die Dauer der Abkühlphase liegt beispielsweise in der Größenordnung von 10 Sekunden bis 15 Sekunden.

Beim Überfahren der Lotwelle 35 steigt die Temperatur T_{B} auf der zweiten Seite B durch den unmittelbaren Kontakt mit der Lotwelle 35 kurzzeitig auf einen hohen Maximalwert T_{B}^{max}. Der Temperaturanstieg dauert, je nach Transportgeschwindigkeit, regelmäßig weniger als 10 Sekunden, häufig sogar nur 1 bis 2 Sekunden. Währenddessen steigt die Temperatur T_{A} auf der ersten Seite A aufgrund der abschirmenden Wirkung der Leiterplatte 1 und der kurzen Zeitdauer während der die Leiterplatte 1 der Wärme der Lotwelle 35 ausgesetzt ist, nur auf einen sehr viel niedrigeren unterhalb der Schmelztemperatur T_{S} liegenden Maximalwert T_{A}^{max} an.

Dabei ist der Unterschied zwischen den beiden Maximalwerten T_{A}^{max}, T_{B}^{max} umso größer, je größer der Anstellwinkel ist, unter dem die Leiterplatte 1 über die Lotwelle 35 gefahren wird, und je größer die Geschwindigkeit ist, mit der sie die Lotwelle 35 überfährt.

Aufgrund der verfahrens-bedingten deutlichen Unterschiede der Maximalwerte T_{A}^{max}, T_{B}^{max} der beiden Temperaturverläufe T_{A}(t), T_{B}(t) können für das Wellenlöten ohne Weiteres Lote eingesetzt werden, die eine deutlich höhere Schmelztemperatur aufweisen, als das auf der ersten Seite A der Leiterplatte 1 eingesetzte niedrig schmelzende Lot 13, 15, ohne dass die auf der ersten Seite A verlöteten Lötstellen während des Wellenlötvorgangs die Schmelztemperatur T_{S} des für sie verwendeten Lots 13, 15 erreichen. Für das Wellenlöten eignet sich beispielsweise ein Zinn-Silber Lot mit einer Schmelztemperatur in der Größenordnung von ca. 220°C oder ein Zinn-Kupfer Lot mit einer Schmelztemperatur in der Größenordnung von 230°C.

Die Höhe des Schmelzpunkts des Lots der Lotwelle 35, ist nach oben jedoch insofern begrenzt, als der von der Transportgeschwindigkeit und dem Anstellwinkel abhängige Maximalwert T_{A}^{max} der auf der ersten Seite A beim Überfahren der Lotwelle 35 auftretenden Temperatur T_{A} die Schmelztemperatur T_{S} des auf der ersten Seite der Leiterplatte 1 verwendeten Lots 13, 15 nicht übersteigen darf.
- 1: Leiterplatte
- 3: THT-Bauteil
- 5: SMD-Bauteil
- 7: SMD-Bauteil
- 9: SMD-Bauteil
- 11: Kleber
- 13: Lot
- 15: Lot
- 17: Kontakt
- 19: Kontakt
- 21: Anschluss
- 23: Metallisierung
- 25: Bohrung
- 27: Vorwärmeinrichtung
- 29: Heißluftgebläse
- 31: Infrarot-Strahler
- 33: Wellenlöteinrichtung
- 35: Lotwelle

## Patentansprüche

1. Verfahren zur Herstellung von mischbestückten Leiterplatten (1), auf deren erster Seite (A) mindestens ein THT-Bauteil (3) und mindestens ein SMD-Bauteil (5, 7) und auf deren zweiter Seite (B) mindestens ein SMD-Bauteil (9) angeordnet ist, bei dem
- die auf der zweiten Seite (B) anzuordnenden SMD-Bauteile (9) an dafür vorgesehenen Positionen auf der zweiten Seite (B) der Leiterplatte (1) befestigt werden,
- die auf der ersten Seite (A) anzuordnenden SMD-Bauteile (5, 7) unter Zwischenfügung eines eine niedrige Schmelztemperatur (Ts) aufweisenden Lots (13, 15) auf für deren Anschluss auf der ersten Seite (A) vorgesehene Kontakte (17, 19) aufgesetzt werden, wobei das die niedrige Schmelztemperatur (Ts) aufweisende Lot (13, 15) eine Schmelztemperatur kleiner gleich 210°C aufweist,
- die erste Seite (A) mit den darauf anzuordnenden THT-Bauteilen (3) und den darauf anzuordnenden SMD-Bauteilen (5, 7) bestückt wird,
- die bestückte Leiterplatte (1) eine Vorwärmeinrichtung (27) während eines vorgegebenen Vorwärmintervalls (ΔT1) durchläuft, wobei die zweite Seite (B) der Leiterplatte (1) der Vorwärmeinrichtung (27) zugewandt ist und eine Heizleistung und eine Dauer des Vorwärmintervalls (ΔT1) derart bemessen sind, dass eine Temperatur (TA) auf der ersten Seite (A) am Ende des Vorwärmintervalls (ΔT1) für einen zum Aufschmelzen des auf der ersten Seite (A) befindlichen Lots (13, 15) ausreichend langen Löt-Zeitraum (ΔTL) geringfügig größer oder gleich der Schmelztemperatur (Ts) des Lots (13,15) ist, so dass das die niedrige Schmelztemperatur (Ts) aufweisende Lot (13, 15) aufgeschmolzen und die auf der ersten Seite (A) angeordneten SMD-Bauteile (5, 7) verlötet werden, und nach dem Durchlaufen der Vorwärmeinrichtung (27)
- die auf der zweiten Seite (B) befindlichen SMD-Bauteile (9) und die auf der zweiten Seite (B) befindlichen Lötstellen der auf der ersten Seite angeordneten THT-Bauteile (3) in einem Wellenlötverfahren verlötet werden, wobei die zweite Seite (B) der Leiterplatte (1) einer Lotwelle zugewandt ist.

2. Verfahren nach Anspruch 1, bei dem das die niedrige Schmelztemperatur (Ts) aufweisende Lot (13, 15) ein Zinn-Wismut Lot, insb. ein Zinn-Wismut Lot mit einer Schmelztemperatur (Ts) in der Größenordnung von 140°C, ist.

3. Verfahren nach Anspruch 1, bei dem das die niedrige Schmelztemperatur (Ts) aufweisende Lot (13, 15) ein Indium- und/oder Wismut-haltiges Lot, insb. ein Indium- und/oder Wismut-haltiges Lot mit einer Schmelztemperatur (Ts) in der Größenordnung von 160°C bis 210°C, ist.

4. Verfahren nach Anspruch 3, bei dem das die niedrige Schmelztemperatur (Ts) aufweisende Lot (13, 15) ein Indium- und/oder Wismut-haltiges Zinn-Silber Lot, insb. ein Sn3.5Ag0.5Bi6In Lot, ist.

5. Verfahren nach Anspruch 1, bei dem für das Wellenlötverfahren ein Lot eingesetzt wird,
- dessen Schmelztemperatur höher ist, als die des auf der ersten Seite (A) der Leiterplatte (1) verwendeten, die niedrige Schmelztemperatur (Ts) aufweisenden Lots (13, 15), und
- dessen Schmelztemperatur niedriger als eine Schmelztemperatur desjenigen Lotwellenlots ist, bei dessen Verwendung ein Maximalwert (T_{A}^{max}) einer beim Wellenlöten auf der ersten Seite (A) der Leiterplatte (1) auftretenden Temperatur (T_{A}) die Schmelztemperatur (T_{S}) des auf der ersten Seite der Leiterplatte (1) verwendeten Lots (13, 15) erreicht.

6. Verfahren nach Anspruch 1, bei dem die auf der zweiten Seite (B) anzuordnenden SMD-Bauteile (9) an dafür vorgesehenen Positionen auf der zweiten Seite (B) der Leiterplatte (1) mittels eines Klebers (11) aufgeklebt werden.

7. Verfahren nach Anspruch 1, bei dem das die niedrige Schmelztemperatur (Ts) aufweisende Lot (13) auf der ersten Seite (A) der Leiterplatte (1) als Lotpaste auf darauf befindliche Kontakte (13) für auf der ersten Seite (A) anzuordnende SMD-Bauteile (5) aufgebracht wird.

8. Verfahren nach Anspruch 1, bei dem
- mindestens eines der auf der ersten Seite (A) anzuordnenden SMD-Bauteile (7) auf dessen der Leiterplatte (1) zuzuwendenden Unterseite angeordnete Lotkugeln aufweist, die aus dem die niedrige Schmelztemperatur (Ts) aufweisenden Lot (15) bestehen, und
- diese SMD-Bauteile (7) derart auf die erste Seite (A) der Leiterplatte (1) aufgebracht werden, dass deren Lotkugeln auf zugehörigen Kontakten (19) auf der ersten Seite (A) der Leiterplatte (1) aufliegen.

9. Fertigungseinrichtung zur Ausführung eines Verfahren zur Herstellung von mischbestückten Leiterplatten (1) gemäß einem der vorangehenden Ansprüche, mit
- einer Vorrichtung zur Befestigung der auf der zweiten Seite (B) anzuordnenden SMD-Bauteile (9) an dafür vorgesehenen Positionen,
-- insb. einem Dispenser zum Aufbringen von Kleber (11) und einem Bestückungsautomaten,
- einer Vorrichtung mit der die auf der ersten Seite (A) anzuordnenden SMD-Bauteile (5, 7) unter Zwischenfügung des die niedrige Schmelztemperatur (Ts) aufweisenden Lots (13, 15) auf für deren Anschluss auf der ersten Seite vorgesehen Kontakte (17, 19) aufgesetzt werden, wobei das die niedrige Schmelztemperatur (Ts) aufweisende Lot (13, 15) eine Schmelztemperatur kleiner gleich 210°C aufweist,
-- insb. einer Druckvorrichtung zum Bedrucken der Leiterplatte (1) mit Lotpaste aus dem die niedrige Schmelztemperatur (TS) aufweisenden Lot (13) und einem Bestückungsautomaten,
- einer Vorrichtung, insb. einem Bestückungsautomaten, zur Bestückung der ersten Seite (A) der Leiterplatte (1) mit den darauf anzuordnenden THT-Bauteilen (3) und den darauf anzuordnenden SMD-Bauteilen (5, 7),
- einer Vorwärmeinrichtung (27), insb. eine mit einem Heißluftgebläse (29) und mindestens einem Infrarotstrahler (31) ausgestattete Vorwärmeinrichtung (27), die dazu eingerichtet ist, die Heizleistung und die Dauer des Vorwärmintervalls (ΔT1), in dem die bestückte Leiterplatte die Vorwärmeinrichtung durchläuft, derart zu bemessen, dass die Temperatur (TA) auf der ersten Seite (A) am Ende des Vorwärmintervalls (ΔT1) für den zum Aufschmelzen des auf der ersten Seite (A) befindlichen Lots (13, 15) ausreichend langen Löt-Zeitraum (ΔTL) geringfügig größer oder gleich der Schmelztemperatur (Ts) des Lots (13,15) ist, so dass das die niedrige Schmelztemperatur (Ts) aufweisende Lot (13, 15) aufschmilzt und die auf der ersten Seite (A) angeordneten SMD-Bauteile (5, 7) verlötet sind, und
- einer Wellenlöteinrichtung (33).

## Claims

1. Procedure for the manufacture of printed circuit boards (1) with mixed components, on the first side (A) of which at least one THT component (3) and at least one SMD component (5, 7) are arranged, and on the second side (B) of which at least one SMD component (9) is arranged, wherein in said procedure
- the SMD components (9) to be arranged on the second side (B) are secured on positions provided for this purpose on the second side (B) of the printed circuit board (1),
- the SMD components (5, 7) to be arranged on the first side (A) are placed on contacts (17, 19) which are provided for their connection on the first side (A) by inserting a solder (13, 15) having a low melting temperature (Ts), wherein the solder (13, 15) having the low melting temperature (Ts) has a melting temperature less than or equal to 210 °C,
- the first side (A) is equipped with the THT components (3) to be arranged thereon and with the SMD components (5, 7) to the arranged thereon,
- the equipped printed circuit board (1) passes through a preheating unit (27) during a predefined preheating interval (ΔT1), wherein the second side (B) of the printed circuit board (1) faces towards the preheating unit (27) and a heating power and a duration of the preheating interval (ΔT1) are sized in such a way that a temperature (TA) on the first side (A) is, at the end of the preheating interval (ΔT1), slightly greater than or equal to the melting temperature (Ts) of the solder (13, 15) for a solder period (ΔTL) which is long enough to melt the solder (13, 15) situated on the first side (A), such that the solder (13, 15) having the low melting temperature (Ts) is melted and the SMD components (5, 7) arranged on the first side (A) are soldered, and after passing through the preheating unit (27)
- the SMD components (9) situated on the second side (B) and the solder points, situated on the second side (B), of the THT components (3) arranged on the first side are soldered using a wave soldering process, wherein the second side (B) of the printed circuit board (1) faces towards a solder wave.

2. Procedure as claimed in Claim 1, wherein the solder (13, 15) having the low melting temperature (Ts) is a tin-bismuth solder, particularly a tin-bismuth solder with a melting temperature (Ts) in the range of 140 °C.

3. Procedure as claimed in Claim 1, wherein the solder (13, 15) having the low melting temperature (Ts) is a solder containing indium and/or bismuth, particularly a solder containing indium and/or bismuth with a melting temperature (Ts) in the range of 160 °C to 210 °C.

4. Procedure as claimed in Claim 3, wherein the solder (13, 15) having the low melting temperature (Ts) is a tin-silver solder containing indium and/or bismuth, particularly a solder Sn3.5Ag0.5Bi6ln.

5. Procedure as claimed in Claim 1, wherein a solder is used for the wave soldering process
- whose melting temperature is higher than that of the solder (13, 15) having the low melting temperature (Ts) used on the first side (A) of the printed circuit board (1), and
- whose melting temperature is lower than a melting temperature of the wave solder, wherein when said solder is used, a maximum value (T_{A}^{max}) of a temperature (T_{A}) occurring during the wave welding process on the first side (A) of the printed circuit board (1) reaches the melting temperature (Ts) of the solder (13, 15) used on the first side of the printed circuit board (1).

6. Procedure as claimed in Claim 1, wherein the SMD components (9) to be arranged on the second side (B) are stuck to positions provided for this purpose on the second side (B) of the printed circuit board (1) using an adhesive (11).

7. Procedure as claimed in Claim 1, wherein the solder (13, 15) having a low melting temperature (Ts) is applied as a solder paste on the first side (A) of the printed circuit board (1) on contacts (13) located on said board for SMD components (5) to be arranged on the first side (A).

8. Procedure as claimed in Claim 1, wherein
- at least one of the SMD components (7) to be arranged on the first side (A) has solder balls on its underside to be turned towards the printed circuit board (1), said solder balls being made from the solder (15) having the low melting temperature (Ts), and
- wherein these SMD components (7) are applied on the first side (A) of the printed circuit board (1) in such a way that their solder balls rest on associated contacts (19) on the first side (A) of the printed circuit board (1).

9. Production equipment to perform a procedure for the manufacture of printed circuit boards (1) with mixed components as claimed in one of the previous claims, with
- a device designed to fix in place the SMD components (9) on the second side (B) at positions provided for this purpose,
-- particularly a dispenser for the application of adhesive (11) and an automatic placement machine,
- a device with which the SMD components (5, 7) to be arranged on the first side (A) are placed on contacts (17, 19) provided for their connection on the first side by inserting the solder (13, 15) having a low melting temperature (Ts), wherein the solder (13, 15) having the low melting temperature (Ts) has a melting temperature less than or equal to 210°C,
-- particularly an imprinting device designed to imprint the printed circuit board (1) with solder paste from the solder (13) with the low melting temperature (TS) and a placement machine,
- a device, particularly a placement machine, designed to equip the first side (A) of the printed circuit board (1) with the THT components (3) to be arranged on the board and the SMD components (5, 7) to be arranged thereon,
- a preheating unit (27), particularly a preheating unit (27) equipped with a hot air fan (29) and at least an infrared radiator (31), said device being configured to set the heating power and the duration of the preheating interval (ΔT1) in which the equipped printed circuit board passes through the preheating unit in such a way that the temperature (TA) on the first side (A) is, at the end of the preheating interval (ΔT1), slightly greater than or equal to the melting temperature (Ts) of the solder (13, 15) for the solder period (ΔTL) which is long enough to melt the solder (13, 15) situated on the first side (A), such that the solder (13, 15) having the low melting temperature (Ts) is melted and the SMD components (5, 7) arranged on the first side (A) are soldered, and
- a wave solder unit (33).

## Revendications

1. Procédé destiné à la fabrication de cartes de circuit imprimé (1) à équipement mixte, sur la première face (A) desquelles sont disposés un composant THT (3) et au moins un composant CMS (5, 7), et sur la deuxième face (B) desquelles est disposé au moins un composant CMS (9), procédé pour lequel
- les composants CMS (9) à disposer sur la deuxième face (B) sont fixés à des emplacements prévus à cet effet sur la deuxième face (B) de la carte de circuit imprimé (1),
- les composants CMS (5, 7) à disposer sur la première face (A) sont placés sur des contacts (17, 19) prévus pour leur connexion sur la première face (A) avec interposition d'une soudure (13, 15) présentant une température de fusion basse (Ts), la soudure (13, 15) présentant la température de fusion basse (Ts) ayant une température de fusion inférieure ou égale à 210 °C,
- la première face (A) est équipée des composants THT (3) à y disposer et des composants CMS (5, 7) à y disposer,
- la carte de circuit imprimé (1) équipée passe à travers un dispositif de préchauffage (27) pendant un intervalle de préchauffage prédéterminé (ΔT1), la deuxième face (B) de la carte de circuit imprimé (1) faisant face au dispositif de préchauffage (27) et une puissance de chauffage et une durée de l'intervalle de préchauffage (ΔT1) étant dimensionnées de telle manière qu'une température (TA) sur la première face (A) à la fin de l'intervalle de préchauffage (ΔT1) est légèrement supérieure ou égale à la température de fusion (T_{S}) de la soudure (13, 15) pendant une période de soudure (ΔTL) qui est suffisamment longue pour faire fondre la soudure (13, 15) située sur la première face (A), de sorte que la soudure (13, 15) présentant la température de fusion basse (Ts) est fondue et les composants CMS (5, 7) disposés sur la première face (A) sont soudés, et après avoir traversé le dispositif de préchauffage (27)
- les composants CMS (9) situés sur la deuxième face (B) et les soudures situées sur la deuxième face (B) des composants THT (3) disposés sur la première face sont soudés par un procédé de soudage à la vague, la deuxième face (B) de la carte de circuit imprimé (1) étant tournée vers une vague de soudure.

2. Procédé selon la revendication 1, pour lequel la soudure (13, 15) présentant une température de fusion basse (Ts) est une soudure à l'étain-bismuth, notamment une soudure à l'étain-bismuth avec une température de fusion (Ts) de l'ordre de 140 °C.

3. Procédé selon la revendication 1, pour lequel la soudure (13, 15) présentant une température de fusion basse (Ts) est une soudure contenant de l'indium et/ou du bismuth, notamment une soudure contenant de l'indium et/ou du bismuth avec une température de fusion (Ts) de l'ordre de 160 °C à 210 °C.

4. Procédé selon la revendication 3, pour lequel la soudure (13, 15) présentant une température de fusion basse (Ts) est une soudure à l'étain-argent contenant de l'indium et/ou du bismuth, notamment une soudure Sn3.5Ag0.5Bi6ln.

5. Procédé selon la revendication 1, pour lequel l'on utilise, pour le procédé de soudage à la vague, une soudure
- dont la température de fusion est supérieure à celle de la soudure (13, 15) présentant la température de fusion basse (Ts), utilisée sur la première face (A) de la carte de circuit imprimé (1), et
- dont la température de fusion est inférieure à une température de fusion de la soudure à la vague, pour l'utilisation de laquelle une valeur maximale (T_{A}^{max}) d'une température (T_{A}) survenant lors du soudage à la vague sur la première face (A) de la carte de circuit imprimé (1) atteint la température de fusion (Ts) de la soudure (13, 15) utilisée sur la première face de la carte de circuit imprimé (1).

6. Procédé selon la revendication 1, pour lequel les composants CMS (9) à disposer sur la deuxième face (B) sont collées à des emplacements prévus à cet effet sur la deuxième face (B) de la carte de circuit imprimé (1) au moyen d'une colle (11).

7. Procédé selon la revendication 1, pour lequel la soudure (13, 15) présentant une température de fusion basse (Ts) est appliquée sur la première face (A) de la carte de circuit imprimé (1) sous la forme d'une pâte à souder sur les contacts (13) s'y trouvant pour les composants CMS (5) à disposer sur la première face (A).

8. Procédé selon la revendication 1, pour lequel
- au moins l'un des composants CMS (7) à disposer sur la première face (A) comporte, sur sa face inférieure tournée vers la carte de circuit imprimé (1), des billes de soudure qui sont constituées de la soudure (15) présentant la température de fusion basse (Ts), et
- ces composants CMS (7) sont appliqués sur la première face (A) de la carte de circuit imprimé (1) de telle manière que leurs billes de soudure reposent sur des contacts associés (19) sur la première face (A) de la carte de circuit imprimé (1).

9. Équipement de fabrication destiné à l'exécution d'un procédé destiné à la fabrication de cartes de circuit imprimé (1) selon l'une des revendications précédentes, avec
- un dispositif destiné à la fixation, à des emplacements prévus à cet effet, des composants CMS (9) sur la deuxième face (B),
-- notamment un distributeur destiné à l'application de colle (11) et un automate d'implantation,
- un dispositif avec lequel les composants CMS (5, 7) à disposer sur la première face (A) sont placés sur des contacts (17, 19) prévus pour leur connexion sur la première face avec interposition de la soudure (13, 15) présentant la température de fusion basse (Ts), la soudure (13, 15) présentant la température de fusion basse (Ts) ayant une température de fusion inférieure ou égale à 210°C,
-- notamment un dispositif d'impression destiné à l'impression de la carte de circuit imprimé (1) avec de la pâte à souder provenant de la soudure (13) à température de fusion basse (TS) et un automate d'implantation,
- un dispositif, notamment un automate d'implantation, destiné à l'équipement de la première face (A) de la carte de circuit imprimé (1) avec les composants THT (3) devant y être disposés et les composants CMS (5, 7) devant y être disposés,
- un dispositif de préchauffage (27), notamment un dispositif de préchauffage (27) équipé d'un pistolet à air chaud (29) et d'au moins un radiateur infrarouge (31), lequel dispositif est conçu pour définir la puissance de chauffage et la durée de l'intervalle de préchauffage (ΔT1), dans lequel la carte de circuit imprimé équipée passe à travers le dispositif de préchauffage, de telle sorte que la température (TA) sur la première face (A) à la fin de l'intervalle de préchauffage (ΔT1), pendant le temps de soudure (ΔTL), qui est suffisamment long pour faire fondre la soudure (13, 15) se trouvant sur la première face (A), est légèrement supérieure ou égale à la température de fusion (Ts) de la soudure (13, 15), de sorte que la soudure (13, 15) présentant la température de fusion basse (Ts) fond et que les composants CMS (5, 7) disposés sur la première face (A) sont soudés, et
- une machine à souder à la vague (33).
